# EUROPEAN PATENT APPLICATION

(11) **EP 4 644 458 A1**
(43) Date of publication of application: **05.11.2025**
(21) Application number: 23911232.9
(22) Date of filing: 27.07.2023
(51) Int. Cl.: C08G 59/68, C09J 11/06, C09J 163/00, C09J 171/00, C09J 201/00, H01L 21/52

(54) **CURABLE RESIN COMPOSITION, ADHESIVE, SEALING MATERIAL, CURED PRODUCT, SEMICONDUCTOR DEVICE, AND ELECTRONIC DEVICE**

(30) Priority: 27.12.2022 JP 2022210521
(71) Applicant: Namics Corporation, Niigata-shi, Niigata 950-3131 (JP)
(72) Inventor: SUZUKI, Fumiya, Niigata-shi, Niigata 950-3131 (JP); IWAYA, Kazuki, Niigata-shi, Niigata 950-3131 (JP)
(74) Representative: Mathys & Squire
(86) International application number: PCT/JP2023/027623
(87) International publication number: WO 2024/142448

(57) **Abstract**

Provided are a curable resin composition, an adhesive, a sealing material, a cured product, a semiconductor device, and an electronic device that can be cured by heating at a low temperature and has an excellent pot life. The curable resin composition contains (A) a cationically curable resin, (B) an acid generator containing an iodonium salt, and (C) a peroxydicarbonate-type organic peroxide represented by Formula (1). The peroxycarbonate-type organic peroxide represented by Formula (1) contains alkyl groups having at least 10 carbon atoms represented by R¹ and R².

## Description

### TECHNICAL FIELD

The present invention relates to a curable resin composition, an adhesive, a sealing material, a cured product, a semiconductor device, and an electronic device.

### BACKGROUND ART

A curable resin composition containing a cationic polymerizable compound is used as an adhesive in the field of electronic components because a cured product thereof is excellent in characteristics such as adhesiveness, electrical insulation properties, chemical resistance, and mechanical strength.

For example, PATENT LITERATURE 1 describes that in a thermal cationic polymerizable composition that can be used in the field of adhesives and the like, a component that is insufficiently cured volatilizes as outgas in a heat resistance test and the like, and contaminates the surroundings. PATENT LITERATURE 1 discloses a thermal cationic polymerizable composition in which an amount of a thermal cation initiator added in the composition is adjusted in order to reduce an amount of the outgas.

### CITATION LIST

### PATENT LITERATURE

PATENT LITERATURE 1: JP-A-2022-105415

### SUMMARY OF INVENTION

### PROBLEMS TO BE SOLVED BY INVENTION

In a case where an adherend to be bonded is a member of a precision instrument such as a camera module or a sensor module, an adhesive capable of being cured at a low temperature is desired. It is also desired that a resin composition used for an adhesive or the like has good storage stability and excellent pot life.

Therefore, an object of the present invention is to provide a curable resin composition, an adhesive, and a sealing material that can be cured by heating at a low temperature of, for example, at least 100°C or lower, preferably 80°C or lower, can be cured by ultraviolet (UV) irradiation, and has an excellent pot life, a cured product obtained by curing them, and a semiconductor device and an electronic device including the cured product.

### SOLUTION TO PROBLEMS

Means for solving the above problems are as follows, and the present invention includes the following aspects.

[1] A curable resin composition containing the following components (A) to (C):
   (A) a cationically curable resin;
   (B) an acid generator containing an iodonium salt; and
   (C) a peroxydicarbonate-type organic peroxide represented by the following Formula (1): 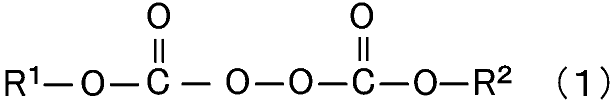 (in Formula (1), R¹ and R² are each independently an alkyl group having at least 10 carbon atoms).
[2] The curable resin composition according to the above [1], in which in Formula (1), R¹ and R² are each independently an alkyl group having at least 11 carbon atoms, which can be a linear, branched, or cyclic alkyl group, or a combination of these three.
[3] The curable resin composition according to claim 1 or 2, in which the iodonium salt contained in the component (B) is an iodonium salt compound represented by the following Formula (2):

   Ar¹ - I⁺ - Ar² ·Z⁻ (2)

   (in Formula (2), Ar¹ and Ar² are each independently a substituted or unsubstituted aryl group, and Z⁻ is an anion).
[4] The curable resin composition according to the above [3], in which Z- in Formula (2) is BF₄⁻, SbF₆⁻, AsF₆⁻, B(C₆F₅)₄⁻, Ga(C₆F₅)₄⁻, C(CF₃SO₂)₃⁻, [P(R³)ₐF₆₋ₐ]⁻, [C(R³SO₂)₃]⁻, or [N(R³SO₂)₂]⁻ (where R³s are each independently an alkyl group in which at least a part of hydrogen atoms is substituted with a fluorine atom, a is an integer of 0 to 5, and in a case where a is an integer of 2 or more, a plurality of R³s may be the same or different from each other).
[5] The curable resin composition according to any one of the above [1] to [4], in which the component (A) contains at least one selected from the group consisting of:
   (A1) an epoxy resin having an epoxy group equivalent of 100 g/eq to 1000 g/eq and having a ring skeleton in a molecule of the epoxy resin; and
   (A2) an oxetane resin.
[6] The curable resin composition according to the above [5], in which the component (A1) contains an epoxy resin having an epoxy group equivalent of 200 g/eq or more.
[7] The curable resin composition according to any one of the above [1] to [6], in which an amount of the component (C) is 0.1 to 10 parts by mass when a total amount of the curable resin composition is 100 parts by mass.
[8] An adhesive or a sealing material containing the curable resin composition according to any one of the above [1] to [7].
[9] A cured product obtained by curing the curable resin composition according to any one of the above [1] to [7], or the adhesive or the sealing material according to the above [8].
[10] The cured product according to the above [9], in which the cured product has a glass transition temperature (Tg) of 0°C to 200°C.
[11] A semiconductor device including the cured product according to the above [9] or [10].
[12] An electronic device including the cured product according to the above [9] or [10].

### EFFECTS OF INVENTION

According to the present invention, it is possible to provide a curable resin composition, an adhesive, and a sealing material that can be cured by heating at a low temperature of 100°C or lower, preferably 80°C or lower, and has an excellent pot life, a cured product obtained by curing them, and a semiconductor device and an electronic device including the cured product.

### DESCRIPTION OF EMBODIMENTS

Hereinafter, a curable resin composition, an adhesive, a sealing material, a cured product obtained by curing them, a semiconductor device and an electronic component including the cured product according to the present disclosure will be described based on embodiments. However, the following embodiments are examples for embodying a technical idea of the present invention, and the present invention is not limited to the following curable resin composition, adhesive, sealing material, cured product, semiconductor device, and electronic component. In the present specification, following the convention in the field of synthetic resins, for a component constituting a curable resin composition before curing, a name including a term "resin" usually indicating a polymer (particularly a synthetic polymer) may be used although the component is not a polymer.

### Resin composition

The cured resin composition according to a first embodiment of the present invention is a curable resin composition containing: (A) a cationically curable resin (hereinafter, also referred to as "component (A)"); (B) an acid generator containing an iodonium salt (hereinafter, also referred to as "component (B)"); and (C) a peroxydicarbonate-type organic peroxide represented by the following Formula (1) (hereinafter, also referred to as "component C"): 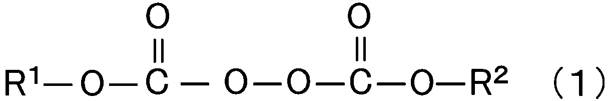 (in Formula (1), R¹ and R² are each independently an alkyl group having at least 10 carbon atoms).

A curable resin composition from which a cured product is obtained by a radical redox reaction using an iodonium salt-based cationic polymerization initiator and an organic peroxide as a thermal radical polymerization initiator can be cured at a relatively low temperature, and a cured product having substantially the same physical properties is obtained even in a case where the composition is cured by heat or even in a case where the composition is cured by heat and ultraviolet irradiation.

However, in the curable resin composition that is cured by the radical redox reaction, the reaction temperature tends to depend on stability of the organic peroxide contained in the composition, and as a one-hour half-life temperature of the organic peroxide is lower, the curable resin composition can be cured at a lower temperature. On the other hand, as the one-hour half-life temperature of the organic peroxide contained in the composition is lower, stability of the composition is also impaired, and thus storage stability also tends to be impaired.

The curable resin composition contains a peroxydicarbonate-type organic peroxide represented by Formula (1) of the component (C) and having an alkyl group having at least 10 carbon atoms at both ends. Carbonate radicals generated from the component (C) react quickly to extract hydrogen from other compounds contained in the curable resin composition, to generate unstable alkyl radicals such as primary radicals. Since the unstable alkyl radicals are prone to radical redox reactions, it is considered that a reaction rate of the unstable alkyl radical is faster than that of the curing inhibition by oxygen. Therefore, it is considered that the carbonate radicals generated from the component (C) can rapidly progress a curing reaction of the cationically curable resin. Furthermore, it is considered that since the carbonate radical is faster in hydrogen abstraction reaction than an alkoxy radical, instantaneous radical concentration in curable resin composition system is higher than that of organic peroxides other than the component (C). By this reaction, electrons move from the unstable alkyl radical to the acid generator containing an iodonium salt, the iodonium salt is reductively decomposed, and an acid (a cation: H⁺) is generated regardless of light. Thereafter, a polymerization reaction starts by acting on the cationically curable resin. The peroxydicarbonate-type organic peroxide can efficiently generate the carbonate radicals and can rapidly progress the curing reaction of the cationically curable resin. The curable resin composition can be cured by heating at a low temperature of 100°C or lower, preferably 90°C or lower, more preferably 85°C or lower, and still more preferably 80°C or lower.

In the curable resin composition, the peroxydicarbonate-type organic peroxide represented by Formula (1) of the component (C) generates the carbonate radicals, and generates the unstable alkyl radical in association with the hydrogen abstraction reaction in the curable resin composition, and thus the curing reaction of the cationically curable resin is rapidly advanced. Further, since the peroxydicarbonate-type organic peroxide represented by Formula (1) of the component (C) has an alkyl group having at least 10 carbon atoms bonded to two oxygen atoms at both ends of the peroxydicarbonate, the organic peroxide is less likely to decompose even at a room temperature of, for example, 20°C to 40°C equal to or lower than a heating temperature or even at a low temperature of less than 20°C as compared with the peroxydicarbonate-type organic peroxide having an alkyl group having less than 10 carbon atoms, and the curable resin composition has good storage stability and an excellent pot life.

### Component (A): Cationically curable resin

The cationically curable resin of the component (A) refers to a resin having one or more cationically polymerizable groups in the molecule, and examples of the cationically polymerizable groups include an epoxy group, an oxetanyl group, and a vinyl ether group. Examples of the cationically curable resin include epoxy resins, oxetane resins, polystyrene-based compounds, and vinyl ether compounds. The cationically curable resin of the component (A) preferably has a molecular weight of 100 to 800 and may have a molecular weight of 110 to 780, in order to be cured by heating at a low temperature of, for example, 100°C or lower, preferably 80°C or lower.

In the present specification, functional group equivalent such as epoxy group equivalent and oxetane group equivalent represents a molecular weight of a compound per functional group, and the number of functional group equivalents such as the number of epoxy group equivalents and the number of oxetane group equivalents represents the number of functional groups (equivalent number) per mass (charged amount) of the compound. The epoxy group equivalent or the oxetane group equivalent can be measured in accordance with JIS K7236:2001 (corresponding to ISO3001:1999).

The cationically curable resin of the component (A) preferably contains at least one selected from the group consisting of (A1) an epoxy resin having an epoxy group equivalent of 100 g/eq to 10,000 g/eq and having a ring skeleton in a molecule of the epoxy resin (hereinafter, also referred to as "component (Al)"), and (A2) an oxetane resin (hereinafter, also referred to as "component (A2)"). When the cured resin composition contains in the component (A) at least one selected from the group consisting of the component (A1) an epoxy resin having an epoxy group equivalent of 100 g/eq to 1000 g/eq and having a ring skeleton in the molecule, and (A2) the oxetane resin, the curing reaction proceeds rapidly and it is possible to obtain a curable resin composition that is cured by heating at a low temperature of, for example, 100°C or less, preferably 80°C or less. The component (A) may contain the component (A1) alone, or may contain both the component (A1) and the component (A2).

Examples of the epoxy resin include an aliphatic epoxy resin and an epoxy resin having a ring skeleton in the molecule. The epoxy resin preferably contains (A1) the epoxy resin having an epoxy group equivalent of 100 g/eq to 1000 g/eq and having a ring skeleton in the molecule. Examples of the ring skeleton include an alicyclic skeleton, an aromatic ring skeleton, a heteroaromatic ring skeleton, and a heterocyclic skeleton. The epoxy resin of the component (A1) preferably contains at least one selected from the group consisting of an epoxy resin having an aromatic ring skeleton in the molecule and an epoxy resin having an alicyclic skeleton in the molecule.

In a case where the component (A) contains an epoxy resin that is the component (A1) the epoxy resin having an epoxy group equivalent of 100 g/eq to 1000 g/eq and having a ring skeleton in the molecule, when the epoxy group equivalent is 100 g/eq to 1000 g/eq, a cured product is obtained by curing the curable resin composition by heating at a low temperature of, for example, 100°C or lower, preferably 80°C or lower. In a case where the component (A) contains the epoxy resin, the epoxy group equivalent of the epoxy resin of the component (A1) may be 800 g/eq or less, 600 g/eq or less, 500 g/eq or less, 400 g/eq or less, 120 g/eq or more, 130 g/eq or more, 150 g/eq or more, 180 g/eq or more, is preferably 200 g/eq or more, and may be 250 g/eq or more.

Specific examples of the epoxy resin having an aromatic ring skeleton include, as a polyfunctional epoxy resin, a bisphenol A type epoxy resin (EPICLON (registered trademark) 850, 850-S, EXA-850CRP, EXA-8067, and the like manufactured by DIC Corporation), a special epoxy resin in which a polyalkylene oxide structure is added to the epoxy resin and a bisphenol A skeleton (AER9000 manufactured by Asahi Kasei Corporation, EP-4000S, EP-4003S, and EP-4010S manufactured by ADEKA Corporation), a phenol F type epoxy resin (EPICRON (registered trademark) 830-S, EXA-830LVP, and the like manufactured by DIC Corporation), a bisphenol AD type epoxy resin, a bisphenol S type epoxy resin, a naphthalene type epoxy resin (EPICRON (registered trademark), HP-4032D, HP-720H, and the like manufactured by DIC Corporation), a phenol novolac type epoxy resin (EPICLON (registered trademark) N-740, N-770, and the like manufactured by DIC Corporation), and a cresol volac type epoxy resin (EPICRON (registered trademark), N-660, N-670, N-655-EXP-S, and the like manufactured by DIC Corporation). Specific examples of a polyfunctional epoxy compound contained in the polyfunctional epoxy resin include glycidyl ether of tetra(hydrophenyl)alkane, glycidyl ether of tetrahydroxybenzophenone, and epoxidized polyvinyl phenol. In a monofunctional epoxy resin, examples of a compound contained in the monofunctional epoxy resin include p-tert-butyl phenyl glycidyl ether (ADEKA GLYCILOL (registered trademark), ED-509E, ED-509 S, and the like manufactured by ADEKA Corporation).

The epoxy resin having an alicyclic skeleton only needs to have an alicyclic skeleton in one molecule, and includes a cycloalkylene oxide compound, in which an epoxy group is formed by two carbon atoms and one oxygen atom forming an alicyclic structure. The epoxy resin having an alicyclic skeleton may contain an epoxy compound having an alicyclic skeleton. Examples of the epoxy compound having an alicyclic skeleton include cyclohexane-based, cyclohexyl methyl ester-based, cyclohexyl methyl ether-based, spiro-based, and tricyclodecane-based epoxy compounds. Specific examples of the epoxy resin having an alicyclic skeleton include 3',4'-epoxycyclomethyl-3,4-epoxycyclohexanecarboxylate (CELLOXIDE (registered trademark) 2021P and the like manufactured by Daicel Corporation), (3,3',4,4'-diepoxy)bicyclohexyl (CELLOXIDE (registered trademark) 8010 and the like manufactured by Daicel Corporation), 1,2-epoxy-4-vinylcyclohexane, and 1,2-epoxy-4-(2-oxiranyl)cyclohexane adduct of 2,2-bis(hydroxymethyl)-1-butanol (EHPE3150 and the like manufactured by Daicel Corporation).

Examples of the aliphatic epoxy resin include polyglycidyl ethers of polyhydric alcohols or alkylene oxide adducts thereof. Specific examples of an aliphatic epoxy compound contained in the aliphatic epoxy resin include ethylene glycol diglycidyl ether, diethylene glycol diglycidyl ether, propylene glycol diglycidyl ether, 1,4-butanediol diglycidyl ether, neopentyl glycol diglycidyl ether, 1,6-hexanediol diglycidyl ether, glycerin diglycidyl ether, trimethylolpropane triglycidyl ether (such as Epolite 100MF manufactured by Kyoeisha Chemical Co., Ltd.), and polyethylene glycol diglycidyl ether. Examples of an aliphatic cyclic epoxy resin include hydrogenated bisphenol A diglycidyl ether (such as jER YX8000 manufactured by Mitsubishi Chemical Corporation).

Specific examples of the vinyl ether compound include hydroxybutyl vinyl ether, vinyl ether of 1,4-cyclohexanedimethanol, triethylene glycol divinyl ether, dodecyl vinyl ether, and cyclohexyl vinyl ether.

The oxetane resin of the component (A2) undergoes a polymerization initiation reaction slower than that of the epoxy resin, but is polymerized at a high speed when concentration of a polymerization initiating species is a certain level or more, and thus the cured product is obtained by a reaction in a short time at a low temperature. Specific examples of the oxetane resin include 3-ethyl-3-hydroxymethyloxetane (oxetane alcohol) (such as OXT-101 manufactured by Toagosei Co., Ltd.), 2-ethylhexyl oxetane (such as OXT-212 manufactured by Toagosei Co., Ltd.), xylylene bisoxetane (such as OXT-121 manufactured by Toagosei Co., Ltd.), 3-ethyl-3-{[(3-ethyloxetane-3-yl)methoxy]methyl}oxetane (such as OXT-221 manufactured by Toagosei Co., Ltd.), oxetanyl silsesquioxetane (such as OXT-191 manufactured by Toagosei Co., Ltd.), phenol novolac oxetane (such as PHOX manufactured by Toagosei Co., Ltd.), and 3-ethyl-3-phenoxymethyloxetane (such as OXT-211 manufactured by Toagosei Co., Ltd.).

In a case where the component (A) contains the oxetane resin of the component (A2), the oxetane group equivalent of the oxetane resin is preferably 100 g/eq to 500 g/eq, and may be 110 g/eq to 300 g/eq. In a case where the oxetane resin of the component (A2) is contained in the component (A), when the oxetane group equivalent of the component (A2) is 100 g/eq to 500 g/eq, a cured product cured by heating at a low temperature of, for example, 100°C or lower, preferably 80°C or lower is obtained. In a case where the component (A) contains the oxetane resin of the component (A2), the oxetane group equivalent of the oxetane resin may be 250 g/eq or less.

### Component (B): Acid generator containing iodonium salt

The iodonium salt contained in the acid generator of the component (B) is preferably an iodonium compound represented by the following Formula (2):

Ar¹ - I⁺ - Ar² ·Z⁻ (2)

(in Formula (2), Ar¹ and Ar² are each independently a substituted or unsubstituted aryl group, and Z⁻ is an anion).

The aryl group represents an aromatic hydrocarbon group having 6 to 18 carbon atoms, and examples thereof include a phenyl group, a naphthyl group, and an anthracenyl group. Ar¹ and Ar² in Formula (2) are each independently preferably a phenyl group or a naphthyl group. The aryl group may be unsubstituted or substituted with one or more optional substituents. Examples of the substituent include a linear or branched alkyl group having 1 to 18 carbon atoms, a linear or branched alkoxy group having 1 to 18 carbon atoms, a linear or branched acyloxy group having 2 to 18 carbon atoms, a halogen atom, a cyano group, a nitro group, and a hydroxyl group.

The anion only needs to be a monovalent counter anion, and is preferably a non-antimony-based anion. In Formula (2), the anion represented by Z⁻ is preferably BF₄⁻, SbF₆⁻, AsF₆⁻, B(C₆F₅)₄⁻, Ga(C₆F₅)₄⁻, C(CF₃SO₂)₃⁻, [P(R³)ₐF₆₋ₐ]⁻, [C(R³SO₂)₃]⁻, or [N(R³SO₂)₂]⁻ (where R³s are each independently an alkyl group in which at least a part of hydrogen atoms is substituted with a fluorine atom, a is an integer of 0 to 5, and in a case where a is an integer of 2 or more, a plurality of R³s may be the same or different from each other). In Formula (2), nucleophilicity of the anion represented by Z⁻ is preferably relatively low, and when the nucleophilicity of the anion contained in the iodonium salt is low, rate of growth reaction of the cationically curable resin is high, and the cured product can be obtained at a low temperature of 100°C or lower in a short time.

Specific examples of the component (B) include diphenyliodonium hexafluoroarsenate, di(4-chlorophenyl)iodonium hexafluoroarsenate, di(4-bromphenyl)iodonium hexafluoroarsenate, phenyl(4-methoxyphenyl)iodonium hexafluoroarsenate, 4-methylphenyl-4-(1-methylethyl)phenyliodonium hexafluorophosphate, 4-methylphenyl-4-(1-methylethyl)phenyliodonium tri(pentafluoroethyl)trifluorophosphate (for example, IK-1 manufactured by San-Apro Ltd.), 4-methylphenyl-4-(1-methylethyl)phenyliodonium tetrakis(pentafluorophenyl) borate, 4-methylphenyl-4-(2-methylpropyl)phenyliodonium hexafluorophosphate (for example, IRGACURE (registered trademark) 250 manufactured by BASF SE), bis(C₁₀₋₁₄-alkylphenyl)iodonium hexafluorophosphate (for example, WPI-113 manufactured by FUJIFILM Wako Pure Chemical Corporation), 4-methylphenyl-4-(1-methylethyl) phenyliodonium hexafluoroantimonate (for example, WPI-116 and the like manufactured by FUJIFILM Wako Pure Chemical Corporation), IK-1FG (manufactured by San-Apro Ltd.), and 4-isopropyl-4'-methyldiphenyliodonium tetrakis(pentafluorophenyl)borate (for example, Bluesil (registered trademark) PI2074 and the like manufactured by ELKEM SILICONES). As such an iodonium salt, for example, a commercially available product can be used as a cationic initiator or as the iodonium salt contained in the acid generator.

### Component (C): peroxydicarbonate-type organic peroxide

The peroxydicarbonate-type organic peroxide represented by the following Formula (1) of the component (C) and having an alkyl group having at least 10 carbon atoms at both ends is a radical source and generates the carbonate radicals. The generated carbonate radicals react quickly to extract hydrogen from other compounds contained in the curable resin composition, to generate unstable alkyl radicals such as primary radicals. Since the unstable alkyl radicals are highly reactive and prone to radical redox reactions, it is considered that a reaction rate of the radical redox reaction is faster than that of curing inhibition by oxygen. Therefore, it is considered that the curing reaction of the cationically curable resin can be rapidly advanced. An organic peroxide other than the peroxydicarbonate-type, for example, an alkyl peroxyester type organic peroxide is likely to generate an oxygen radical. The generated oxygen radical is likely to generate a stable alkyl radical in association with self-cleavage or decarboxylation reaction. It is considered that the stable alkyl radical has low reactivity, and a reaction of inhibition by oxygen is higher than electron transfer to the acid generator containing the iodonium salt. This effect makes it difficult for the iodonium salt to decompose. Therefore, it is considered that the acid (cation: H⁺) is less likely to be generated, and thus the polymerization reaction is easily inhibited. 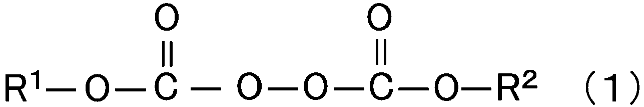 (in Formula (1), R¹ and R² are each independently an alkyl group having at least 10 carbon atoms)

In Formula (1), R¹ and R² are each independently the alkyl group having at least 10 carbon atoms, and more preferably an alkyl group having at least 11 carbon atoms. In Formula (1), when R¹ and R² are each independently the alkyl group having at least 10 carbon atoms, preferably each independently the alkyl group having at least 11 carbon atoms, the organic peroxide is less likely to decompose even at the room temperature of, for example, 20°C to 40°C equal to or lower than the heating temperature or even at the low temperature of less than 20°C, and the curable resin composition has good storage stability and an excellent pot life. In Formula (1), R¹ and R² may be each independently an alkyl group having 30 or less carbon atoms. In Formula (1), R¹ and R² may be the same or different. In the peroxydicarbonate-type organic peroxide of the component (C), R¹ and R² in Formula (1) may be each independently a linear, branched, or cyclic alkyl group, or a combination of these three. In the peroxydicarbonate-type organic peroxide of the component (C), R¹ and R² in Formula (1) are preferably each independently a linear or branched alkyl group having at least 10 carbon atoms. In Formula (1), when R¹ and R² are each independently the linear or branched alkyl group having at least 10 carbon atoms, even in a case where radicals are generated by heating at a low temperature of 100°C or lower, preferably 80°C or lower, the organic peroxide is less likely to decompose even at the room temperature of, for example, 20°C to 40°C equal to or lower than the heating temperature or even at the low temperature of lower than 20°C, and the curable resin composition has better storage stability and an excellent pot life.

The one-hour half-life temperature of the peroxydicarbonate-type organic peroxide represented by Formula (1) of the component (C) is preferably 50°C to 80°C, may be 55°C to 75°C, and is preferably 55°C to 70°C. When the one-hour half-life temperature of the peroxydicarbonate-type organic peroxide of the component (C) is 50°C to 80°C, radicals are generated by heating at a low temperature of, for example, 100°C or lower, preferably 80°C or lower, and the iodonium salt is reductively decomposed, so that the polymerization reaction of the cationically curable resin can be promoted. The peroxydicarbonate-type organic peroxide represented by Formula (1) of the component (C) preferably has a molecular weight of 200 to 1000, and may have a molecular weight of 250 to 800 or 300 to 700 or less.

Examples of the peroxydicarbonate-type organic peroxide of the component (C) include di(4-tert-butylcyclohexyl) peroxydicarbonate (for example, PEROYL TCP and the like manufactured by NOF CORPORATION), dicetyl peroxydicarbonate (for example, Perkadox 24L and the like manufactured by Nouryon), dimyristyl peroxydicarbonate (for example, Perkadox 26 and the like manufactured by Nouryon), ditridecyl peroxydicarbonate (manufactured by Alfa Chemistry), and distearyl peroxydicarbonate (manufactured by SAGECHEM LIMITED).

The curable resin composition may contain at least one selected from the group consisting of (D) a photosensitizer, (E) a photoradical generator, and (F) a filler (hereinafter, also respectively referred to as "component (D)", "component (E)", and "component (F)"). The curable resin composition may further contain at least one selected from the group consisting of (G) a coupling agent, (H) an ion trapping agent, and (I) a colorant such as a pigment (hereinafter, also respectively referred to as "component (G)", "component (H)", and "component (I)"). At least one component selected from the group consisting of the coupling agent (G), the ion trapping agent (H), and the colorant (I) may be contained as an optional component.

### (D) Photosensitizer

The photosensitizer is a component for increasing sensitivity of the iodonium salt to light. Examples of the photosensitizer include thioxanthone derivatives, carbonyl compounds, organic sulfur compounds, persulfides, redox-based compounds, azo and diazo compounds, halogen compounds, and photoreducible coloring matter, and the thioxanthone derivatives are preferable. Specific examples of the thioxanthone derivatives include isopropylthioxanthone, 2,4-diethylthioxanthone, 2-chlorothioxanthone, 2,4-diethylthioxanthone, 2-chlorothioxanthone, and thioxanthone ammonium salt, and 2,4-diethylthioxanthone is preferable.

### (E) Photoradical generator

The photoradical generator is a radical source together with the peroxydicarbonate-type organic peroxide of the component (C), generates an alkyl radical by irradiation with light, reductively decomposes the iodonium salt, generates the acid (cation: H⁺) by light, and promotes the polymerization reaction. Since the curable resin composition of the present invention contains the peroxydicarbonate-type organic peroxide of the component (C), it may not contain the photoradical generator (E). In a case where the curable resin composition contains the photoradical generator (E), the alkyl radical is produced by light to reductively decompose the iodonium salt, and the acid (cation: H⁺) is also produced by light to further promote the polymerization reaction. Examples of the photoradical generator include 1-hydroxycyclohexyl phenyl ketone (for example, Omnirad (registered trademark) 184 and the like manufactured by IGM Resins), 1-[4-(2-hydroxyethoxy)-phenyl]-2-hydroxy-2-methyl-1-propane-1-one, 2-hydroxy-1-{4-[4-(2-hydroxy-2-methyl-propionyl)-benzyl]phenyl}-2-methyl-propane-1-one, and 2-hydroxy-2-methyl-1-phenylpropane-1-one.

### (F) Filler

The filler is a component for improving fluidity, injectability, coatability, adhesiveness, and the like of the curable resin composition. When the filler is contained in the curable resin composition, a cured product having good adhesiveness to an adherend is obtained even in a case where the curable resin composition is cured by heating at a low temperature of 100°C or lower, preferably 80°C or lower. Examples of the filler include known inorganic fillers or organic fillers. The filler may be used alone or in combination of two or more kinds.

Examples of the inorganic filler include calcium carbonate, magnesium carbonate, barium sulfate, magnesium sulfate, aluminum silicate, titanium oxide, alumina, zinc oxide, silicon dioxide (precipitated silica, fumed silica, and the like), kaolin, talc, glass beads, sericite activated clay, aluminum hydroxide, asbestos powder, copper oxide, copper hydroxide, iron oxide, lead oxide, magnesium oxide, tin oxide, carbon, mica, smectite, carbon black, bentonite, aluminum nitride, and silicon nitride. The filler may be added as a thixotropic agent, and the fumed silica is preferable in a case where the filler is added as the thixotropic agent. The fumed silica may be surface treated. Examples of a surface treatment agent of an inorganic thixotropic agent include monoalkyltrialkoxysilane, dimethyldichlorosilane, polydimethylsiloxane, and hexamethyldisilazane. As the surface-treated or untreated fumed silica, a commercially available product can be used. The inorganic filler is preferably silicon dioxide, glass beads, and talc from the viewpoint of adhesiveness to the adherend, and more preferably silicon dioxide from the viewpoint of improving fluidity, injectability, and coatability. Examples of the silicon dioxide include colloidal silica, hydrophobic silica (for example, Cabosil (registered trademark) TS720 and the like manufactured by Cabot Japan K.K.), spherical silica (for example, high purity synthetic spherical silica SE5200SEE and the like manufactured by Admatechs Co., Ltd.), and nanosilica. As for silicon dioxide, two or more kinds having different types or different particle sizes may be used in combination, or one kind may be used alone.

Examples of the organic filler include acrylic particles, polymethyl methacrylate, polystyrene (polystyrene beads), a copolymer obtained by copolymerizing a monomer constituting them (that is, methyl methacrylate or styrene) with another monomer, polyethylene particles, polysiloxane resin particles, polyamide particles, polyester fine particles, polyurethane fine particles, and rubber fine particles (acrylic rubber particles, isoprene rubber particles). The organic filler may have a core-shell structure. The polysiloxane resin particles may be silicone particles. From the viewpoint of adhesiveness, the organic filler is preferably the rubber fine particles, and particularly preferably the rubber fine particles having a core-shell structure. In a case where the filler is the organic filler, a weight average molecular weight of the organic filler is not particularly limited, but is preferably 50,000 to 4,000,000, and particularly preferably 300,000 to 3,000,000. As the weight average molecular weight, a value using a calibration curve by standard polystyrene can be used by gel permeation chromatography (GPC).

The average particle size of the filler is not particularly limited, but is preferably 0.01 µm or more and less than 10 µm, and particularly preferably 0.012 µm or more and 5 µm or less in order to improve fluidity, injectability, coatability, adhesiveness, and the like. The average particle size of the filler can be measured by a laser diffraction type particle size distribution measuring apparatus, a dynamic light scattering type Nanotrac particle size distribution analyzer, or the like. The average particle size may be a 50% cumulative particle size in a volume-based particle size distribution or a 50% cumulative particle size in a number-based particle size distribution.

### (G) Coupling agent

The coupling agent has two or more different functional groups in the molecule, one of which is a functional group chemically bonded to an inorganic material, and the other is a functional group chemically bonded to an organic material. When the curable resin composition contains the coupling agent, the adhesiveness of the curable resin composition can be improved in a case where different types of materials such as a camera module and a sensor module are bonded.

Examples of the coupling agent include a silane coupling agent, an aluminum coupling agent, and a titanium coupling agent, but are not limited thereto. The coupling agent may be used alone or in combination of two or more kinds.

Examples of a functional group of the silane coupling agent include a vinyl group, an epoxy group, a styryl group, a methacrylic group, an acrylic group, an amino group, an isocyanurate group, a ureido group, a mercapto group, a sulfide group, and an isocyanate group. Examples of the silane coupling agent include: silane compounds having an epoxy group and an alkoxy group, and optionally having an alkyl group, such as 2-(3,4-epoxycyclohexyl)ethyltrimethoxysilane 3-glycidoxypropyltrimethoxysilane, 3-glycidoxypropylmethyldiethoxysilane, 3-glycidoxypropyltriethoxysilane; silane compounds having an alkenyl group and an alkoxy group and optionally having an alkyl group, such as vinyltrimethoxysilane and p-styryltrimethoxysilane; silane compounds having a (meth)acrylic group and an alkoxy group and may have an alkyl group, such as 3-methacryloxypropylmethyldimethoxysilane, 3-methacryloxypropyltrimethoxysilane, 3-methacryloxypropylmethyldiethoxysilane, 3-methacryloxypropyltriethoxysilane, and 3-acryloxypropyltrimethoxysilane; silane compounds having a primary or secondary amino group and an alkoxy group, and optionally having an alkyl group, such as N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, and N-phenyl-3-aminopropyltrimethoxysilane; and silane compounds having one or more groups selected from the group consisting of a mercapto group, an isocyanato group, a ureido group, and a halogen atom, and one or more alkoxy groups, and optionally having an alkyl group, such as 3-ureidopropyltriethoxysilane, 3-chloropropyltrimethoxysilane, 3-mercaptopropylmethyldimethoxysilane, 3-mercaptopropyltrimethoxysilane, bis(triethoxysilylpropyl)tetrasulfide, and 3-isocyanatopropyltriethoxysilane.

### (H): Ion trapping agent

The ion trapping agent traps free iodonium ions and improves various kinds of reliability of the cured product. The ion trapping agent is not particularly limited, and can be selected from those generally used as materials such as a sealing material. Specific examples thereof include hydrotalcites, and hydrated oxides of elements such as magnesium, aluminum, titanium, zirconium, and bismuth. Examples of commercially available products include IXEPLAS-A1 and IXEPLAS-A2 manufactured by Toagosei Co., Ltd. The ion trapping agent may be used alone or in combination of two or more kinds.

### (I) Colorant

The colorant can be used for the purpose of coloring the curable resin composition. As the colorant, for example, a pigment, a dye, a coloring matter, or the like can be used. As the colorant, known colorants such as red, blue, green, yellow, black, and white can be used, and examples of the black colorant include carbon black-based, graphite-based, iron oxide-based, titanium black, anthraquinone-based, cobalt oxide-based, copper oxide-based, manganese-based, antimony oxide-based, nickel oxide-based, perylene-based, aniline-based, molybdenum sulfide, and bismuth sulfide. Examples of the pigment as a commercially available product include titanium blacks 13M, 13M-C, and 13M-T manufactured by Mitsubishi Materials Electronic Chemicals Co., Ltd.

Examples of the optional component include, in addition to the coupling agent (G), the ion trapping agent (H), or the colorant (I), an additive, a leveling agent, an antioxidant, an antifoaming agent, a thixotropic agent, a viscosity modifier, a flame retardant, a colorant, a solvent, and the like.

The component (A) in the curable resin composition is preferably 90 mass% or more, may be 91 mass% or more, or may be 92 mass% or more based on 100 mass% of the total amount of the component (A), the component (B), and the component (C) in order to obtain the cured product by heating at a low temperature of, for example, 100°C or less, preferably 80°C or less. The total amount of the component (B) and the component (C) is preferably 10 mass% or less, may be 9 mass% or less, may be 8 mass% or less, and is preferably 1 mass% or more, may be 2 mass% or more, or may be 3 mass% or more based on the total amount of the component (A), the component (B), and the component (C).

In order to obtain a cured product by heating at a low temperature of, for example, 100°C or lower, preferably 80°C or lower, the total amount of the component (A), the component (B), and the component (C) is preferably 50 to 100 mass%, more preferably 55 to 95 mass%, and still more preferably 60 to 90 mass% based on 100 mass% of the total amount of the curable resin composition.

In a case where at least one selected from the group consisting of the epoxy resin having a ring skeleton in the molecule as the component (A1) and the oxetane resin as the component (A2) is contained as the cationically curable resin as the component (A) in the curable resin composition, the total amount of the component (A1) and the component (A2) is preferably 20 to 100 mass%, more preferably 30 to 90 mass%, and still more preferably 30 to 70 mass% when the total amount of the component (A) is 100 mass%. In order to obtain a cured product having a low elastic modulus, when the total amount of component (A) is 100 mass%, the component (A) may all be at least one component selected from the group consisting of the component (A1) and the component (A2) (the total amount of the component (A1) and the component (A2) is 100 mass%). In a case where the total amount of the component (A1) and the component (A2) is less than 100 mass% in the component (A), the remainder excluding the component (A1) and the component (A2) may be at least one selected from the group consisting of an epoxy resin having no ring skeleton in the molecule (for example, an aliphatic epoxy resin), a polystyrene-based compound, and a vinyl ether compound.

In a case where the component (A) in the curable resin composition contains an epoxy resin and the epoxy resin contains the epoxy resin having an aromatic ring skeleton as the component (A1), in order to obtain the cured product by heating at a low temperature of, for example, 100°C or lower, preferably 80°C or lower, the epoxy resin having an aromatic ring skeleton in the component (A) is preferably 20 to 100 mass%, more preferably 15 to 95 mass%, and still more preferably 20 to 95 mass% when the total amount of the component (A) is 100 mass%.

In a case where the component (A) in the curable resin composition contains the epoxy resin and the epoxy resin contains an epoxy resin having an aromatic ring skeleton as the component (A1), in order to cure the curable resin composition by heating at a low temperature of, for example, 100°C or lower, preferably 80°C or lower, a ratio 1 of the number of epoxy group equivalents of the component (A1) to the number of functional group equivalents in the component (A) (functional group equivalent ratio 1 = [number of epoxy group equivalents of component (A1) having an aromatic ring skeleton]/[number of functional group equivalents of component (A)]) is preferably 0.001 to 1.0, more preferably 0.01 to 0.8, and still more preferably 0.1 to 0.6. The number of functional group equivalents in the component (A) refers to a total number of functional group equivalents contained in the component (A), and in a case where the component (A) contains, for example, both the epoxy resin and the oxetane resin, the number of functional group equivalents refers to a total number of epoxy group equivalents and oxetane group equivalents.

In a case where the component (A) in the curable resin composition contains the epoxy resin, in order to obtain a cured product by heating at a low temperature of, for example, 100°C or lower, preferably 80°C or lower, the epoxy resin having an alicyclic skeleton in the component (A) is preferably 0 to 50 mass%, more preferably 0 to 40 mass%, and still more preferably 1 to 30 mass% when the total amount of the component (A) is 100 mass%.

In a case where the component (A) in the curable resin composition contains the epoxy resin and the epoxy resin contains an epoxy resin having an alicyclic skeleton as the component (A1), in order to cure the curable resin composition by heating at a low temperature of, for example, 100°C or lower, preferably 80°C or lower, a ratio 2 of the number of epoxy group equivalents of the component (A1) to the number of functional group equivalents in the component (A) (functional group equivalent ratio 2 = [number of epoxy group equivalents of component (A1) having alicyclic skeleton]/[number of functional group equivalents of component (A)]) is preferably 0.001 to 0.8, more preferably 0.01 to 0.6, and still more preferably 0.1 to 0.5.

In a case where the component (A) in the curable resin composition contains the epoxy resin and the epoxy resin is the aliphatic epoxy resin, the aliphatic epoxy resin in the component (A) may be 0 to 70 mass% or 0 to 60 mass% when the total amount of the component (A) is 100 mass%.

In a case where the component (A) in the curable resin composition contains the epoxy resin and the epoxy resin contains the aliphatic epoxy resin, in order to cure the curable resin composition by heating at a low temperature of, for example, 100°C or lower, preferably 80°C or lower, a ratio 3 of the number of epoxy group equivalents of the aliphatic epoxy resin to the number of functional group equivalents of the component (A) (functional group equivalent ratio 3 = [number of epoxy group equivalents of aliphatic epoxy resin component (A1)]/[number of functional group equivalents of component (A)] is preferably 0.01 to 0.8, more preferably 0.05 to 0.6, and still more preferably 0.1 to 0.5.

In the component (A) in the curable resin composition, the oxetane resin of the component (A2) is preferably 0 to 40 mass%, more preferably 0 to 30 mass%, and still more preferably 0 to 20 mass% when the total amount of the component (A) is 100 mass%. In a case where the oxetane resin of the component (A2) is contained in the component (A), in order to accelerate a curing rate and efficiently obtain the cured product by heating at a low temperature of, for example, 100°C or lower, preferably 80°C or lower, the content of the oxetane resin of the component (A2) is preferably 1 to 40 mass%, more preferably 2 to 30 mass%, and still more preferably 3 to 20 mass% when the total amount of the component (A) is 100 mass%.

In a case where the component (A) in the curable resin composition contains the oxetane resin of the component (A2), in order to cure the curable resin composition by heating at a low temperature of, for example, 100°C or lower, preferably 80°C or lower, a ratio 4 of the number of oxetane group equivalents of the oxetane resin of the component (A2) to the number of functional group equivalents of the component (A) (functional group equivalent ratio 4 = [number of oxetane group equivalents of component (A2)]/[number of functional group equivalents of component (A)]) is preferably 0.001 to 0.8, more preferably 0.01 to 0.6, and still more preferably 0.01 to 0.5.

A blending ratio of the component (A1) to the component (A2) in the component (A) in the curable resin (component (A1):component (A2)) is preferably 100:0 to 60:40, more preferably 99:1 to 70:30, and still more preferably 98:2 to 80:20 in mass ratio. When the blending ratio of the component (A1) to the component (A2) in the component (A) is 100:0 to 60:40, the cured product is obtained by heating at a low temperature of, for example, 100°C or lower, preferably 80°C or lower.

In order to cure the curable resin composition by heating at a low temperature of, for example, 100°C or lower, preferably 80°C or lower, the component (B) in the curable resin is preferably 0.1 to 10.0 parts by mass, more preferably 0.5 to 8 parts by mass, and still more preferably 1.0 to 5 parts by mass based on 100 parts by mass of the component (A).

In order to cure the curable resin composition by heating at a low temperature of, for example, 100°C or lower, preferably 80°C or lower, the component (C) in the curable resin is preferably 0.1 to 10.0 parts by mass, more preferably 0.5 to 8 parts by mass, and still more preferably 1.0 to 5 parts by mass based on 100 parts by mass of the component (A).

A blending ratio of the component (B) to the component (C) in the curable resin (component (B):component (C)) is preferably about the same, and may be 25:75 to 75:25, 30:70 to 70:30, 40:60 to 60:40, or 50:50 in mass ratio.

The photosensitizer of the component (D) in the curable resin composition may be 0 to 3.0 mass%, 0.05 to 3.0 mass%, 0.05 to 2.0 mass%, or 0.1 to 1.0 mass% based on 100 mass% of the total amount of the curable resin composition.

The photoradical generator of the component (E) in the curable resin composition may be 0 to 3.0 mass%, 0.05 to 3.0 mass%, 0.05 to 2.0 mass%, or 0.1 to 1.0 mass% based on 100 mass% of the total amount of the curable resin composition.

The filler of the component (F) in the curable resin composition may be 0 to 50 mass%, 1 to 45 mass%, or 3 to 40 mass% based on 100 mass% of the total amount of the curable resin composition. In order to obtain the cured product by heating the curable resin composition at a low temperature of, for example, 100°C or lower, preferably 80°C or lower, the filler of the component (F) in the curable resin composition is preferably 1 to 45 mass%, and more preferably 3 to 40 mass% based on 100 mass% of the total amount of the curable resin composition.

The above-mentioned optional component in the curable resin composition is 10 mass% or less, may be 0 to 10 mass%, 0.1 to 5 mass%, or 0.3~3 mass% based on 100 mass% of the total amount of the curable resin composition. As described above, at least one selected from the group consisting of the coupling agent (G), the ion trapping agent (H), and the colorant (I) may be contained as the optional component.

### Method for producing curable resin composition

The curable resin composition can be produced by mixing the component (A), the component (B), and the component (C). The curable resin composition can be produced by further mixing the component (D), the component (E), the component (F), the component (G), the component (H), the component (I), and other optional components as necessary. The curable resin composition may be produced by mixing the components together with the additive as necessary. The components can be simultaneously or separately introduced into an appropriate mixer, and stirred and mixed while being melted by heating, if necessary, to obtain the curable resin composition. A method for producing the curable resin composition is not particularly limited. The curable resin composition can be produced by mixing raw materials to be the components with the mixer such as a mortar machine, a Henschel mixer, a roll mill, a three-roll mill, a ball mill, a planetary mixer, or a bead mill equipped with a stirring device and a heating device. In addition, the curable resin composition may be produced by appropriately combining two or more devices.

The curable resin composition is preferably liquid or paste at room temperature, for example, 20°C to 30°C. A viscosity of the curable resin composition is preferably 100 Pa·s or less, or may be 80 Pa·s or less, and is preferably 1 Pa·s or more, when measured immediately after preparing the resin composition (for example, within 30 minutes) and after the curable resin composition is left standing at room temperature, for example, 20°C to 30°C for a predetermined time using a Brookfield rotational viscometer (HBDV-I type or RVDV-I type, spindle: SC4-14 spindle, rotation speed: 50rpm, measurement temperature: 25°C). The viscosity of the curable resin composition at 20°C to 30°C measured by the above-described method may be 3 Pa·s to 10 Pa·s.

### Adhesive or sealing material

The curable resin composition can be used as the adhesive or the sealing material for fixing, bonding, or protecting components constituting the electronic device, the camera module, or the sensor module, and can also be used as the adhesive or the sealing material containing the curable resin composition.

### Method for supplying curable resin composition

The curable resin composition can be supplied using a jet dispenser, an air dispenser, or the like. In addition, it can be supplied by a known coating method (dip coating, spray coating, bar coater coating, gravure coating, reverse gravure coating, spin coater coating, and the like) and a known printing method (plate printing, carton printing, metal printing, offset printing, screen printing, gravure printing, flexographic printing, inkjet printing, and the like).

### Curing conditions of curable resin composition

The resin composition is thermosetting, and can be cured by heating at a temperature of 100°C or lower, preferably 80°C or lower, more preferably 75°C or lower, still more preferably 70°C or higher, preferably 45°C or higher, and more preferably 55°C or higher. A heating time for curing the curable resin composition is preferably 15 minutes or more and 4 hours or less, more preferably 30 minutes or more and 2 hours or less, and still more preferably 30 minutes or more and 60 minutes or less.

### Cured product

The cured product is obtained by curing the curable resin composition, or the adhesive or the sealing material containing the curable resin composition. The cured product is obtained by curing the curable resin composition, for example, at least 100°C or less, preferably 80°C for 60 minutes. The cured product has a glass transition temperature (Tg) of preferably 0°C to 200°C, more preferably 1°C to 150°C, still more preferably 2°C to 130°C, and still more preferably 3°C to 120°C, measured using a dynamic viscoelasticity measuring device (for example, DMA7100 or the like manufactured by Hitachi High-Tech Science Corporation). When the Tg of the obtained cured product is 200°C or lower, a cured product that can be cured at a low temperature is obtained. The glass transition temperature is measured by a tensile method in a range of - 20°C to 250°C, a frequency of 10 Hz, a heating rate of 3°C/min, and a strain amplitude of 5 µm. For the Tg, storage modulus (E') and loss modulus (E") of the cured product are measured, and a peak temperature of dielectric tangent (tan δ) calculated from E"/E' is taken as the Tg.

### Semiconductor device and electronic device

As for the curable resin composition, in a case where the adhesive or the sealing material containing the curable resin composition is used for fixing, bonding, or protecting an electronic component, an electronic device containing the cured product obtained by curing the curable resin composition, or the adhesive or the sealing material containing the curable resin composition can be obtained. The electronic device may be a semiconductor device including a semiconductor element. Examples of the electronic device include a mobile phone, a smartphone, a notebook computer, a tablet terminal, and a camera module. The curable resin composition, and the adhesive or the sealing material containing the curable resin composition can be used for fixing, bonding, or protecting the electronic component, and the electronic device can be provided using
an adhesive capable of being cured by heating at a low temperature of 100°C or lower, preferably 80°C or lower.

### EXAMPLES

Hereinafter, the present invention will be described by way of Examples. The present invention is not limited to these Examples.

The components used in the curable resin compositions of Examples and Comparative Examples are shown below.

### Component (A): Cationically curable resin

### Component (A1): Epoxy resin having a ring skeleton in the molecule

(A1-1): AER9000 (manufactured by Asahi Kasei Corporation), the special epoxy resin containing the compound, in which the polyalkylene oxide structure is added to the epoxy resin and the bisphenol A skeleton, molecular weight is 760, epoxy group equivalent is 380 g/eq
(A1-2): EPICLON (registered trademark) EXA-850CRP (manufactured by DIC Corporation), the bisphenol A type epoxy resin, molecular weight is 344, epoxy group equivalent is 172 g/eq
(A1-3): jER YX8000 (manufactured by Mitsubishi Chemical Corporation), hydrogenated bisphenol A diglycidyl ether, molecular weight is 410, epoxy group equivalent is 205 g/eq
(A1-4): CELLOXIDE (registered trademark) 2021P (manufactured by Daicel Corporation), 3',4'-epoxycyclomethyl-3,4-epoxycyclohexanecarboxylate, molecular weight is 260, epoxy group equivalent is 130 g/eq
(A1-5): ADEKA GLYCILOL (registered trademark) ED-509S (manufactured by ADEKA Corporation), p-tert-butyl phenyl glycidyl ether, molecular weight is 206, epoxy group equivalent is 206/eq

### Component (A): Cationically curable resin

### Component (A2): Oxetane resin

(A2-1): OXT-221 (manufactured by Toagosei Co., Ltd.), 3-ethyl-3-{[(3-ethyloxetane-3-yl)methoxy]methyl}oxetane, molecular weight is 214, oxetane group equivalent is 107 g/eq
(A2-2): OXT-101 (manufactured by Toagosei Co., Ltd.), 3-ethyl-3-hydroxymethyloxetane (oxetane alcohol), molecular weight is 116, oxetane group equivalent is 116 g/eq

### Component (B): Acid generator containing iodonium salt

(B-1): Bluesil (registered trademark) PI2074 (manufactured by ELKEM SILICONES), 4-isopropyl-4'-methyldiphenyliodonium tetrakis(pentafluorophenyl)borate
(B-2): IK-1FG (manufactured by San-Apro Ltd.)

Component (C): peroxydicarbonate-type organic peroxide represented by Formula (1)
(C-1): Perkadox 24L (manufactured by Nouryon), dicetyl peroxydicarbonate, one-hour half-life temperature is 65°C, molecular weight is 570.9, R¹ and R² in Formula (1) are each a hexadecane group having 16 carbon atoms (-(CH₂)₁₅-CH₃), solid (powder) at normal temperature (about 20°C to 25°C) 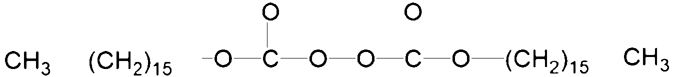
(C-2): Perkadox 26 (manufactured by Nouryon), dimyristyl peroxydicarbonate, molecular weight is 514.8, R¹ and R² in Formula (1) are each a tetradecane group having 14 carbon atoms (-(CH₂)₁₃-CH₃) 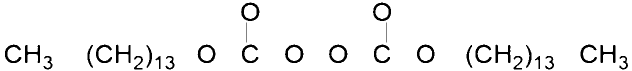
(C-3): PEROYL TCP (manufactured by NOF CORPORATION), bis(4-tert-butylcyclohexyl) peroxydicarbonate, one-hour half-life temperature is 58°C, molecular weight is 398.5, solid (powder) at normal temperature (about 20°C to 25°C) 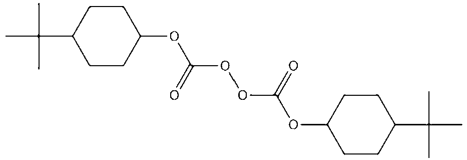
(C-4): ditridecyl peroxydicarbonate (manufactured by Alfa Chemistry), molecular weight is 486.72, solid (powder) at normal temperature (about 20°C to 25°C)
(C-5): distearyl peroxydicarbonate (manufactured by SAGECHEM LIMITED), molecular weight is 626.99, solid (powder) at normal temperature (about 20°C to 25°C)

Component (C'): peroxydicarbonate-type organic peroxide, in which R¹ and R² are each an alkyl group having less than 10 carbon atoms in Formula (1)
(C'-1): Lupelox 225 (manufactured by ARKEMA Yoshitomi, Ltd.), di(secondary butyl) peroxydicarbonate, one-hour half-life temperature is 69°C, molecular weight is 234.2, liquid at normal temperature (about 20°C to 25°C)

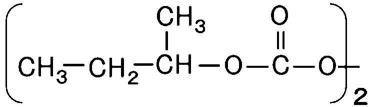

### (D) Photosensitizer

(D-1): DETX, 2,4-diethylthioxanthone (manufactured by Nippon Kayaku Co., Ltd.)

### (E) Photoradical generator

(E-1): Omnirad (registered trademark) 184 (manufactured by IGM Resins), 1-hydroxycyclohexyl phenyl ketone

### (F) Filler

(F-1): SE5200SEE (manufactured by Admatechs Co., Ltd.), high purity synthetic spherical silica, average particle size at 50% cumulative in volume-based particle size distribution by a laser diffraction scattering method is 1.5 µm (catalog value)
(F-2): Cabosil (registered trademark) TS720 (manufactured by Cabot Japan K.K.), hydrophobic silica, average particle size at 50% cumulative in number-based particle size distribution by the laser diffraction scattering method is 0.012 µm (catalog value)

### (G) Coupling agent

(G-1): Silane coupling agent, S530 (manufactured by JNC Corporation), 2-(3,4-epoxycyclohexyl)ethyltrimethoxysilane

### (H): Ion trapping agent

(H-1): IXEPLAS-A1 (manufactured by Toagosei Co., Ltd.), zirconium-magnesium-based ion trapping agent, average particle size is 0.5 µm (catalog value)

### (I) Colorant

(I-1): Titanium black 13M (manufactured by Mitsubishi Materials Electronic Chemicals Co., Ltd.)

### Examples 1 to 11 and Comparative Example 1

A curable resin composition was prepared by mixing components in amounts according to blending ratios shown in Tables 1 and 2 using a three-roll mill. In Tables 1 and 2, numbers indicating the blending ratio of the components contained in the curable resin composition represent mass% based on 100 mass% of the total amount of the curable resin composition unless otherwise specified. In Tables, each component is mainly indicated by a symbol of a product name or a trade name. In Tables, the symbol "-" indicates that the corresponding component is not contained in the curable resin composition.

### Examples 12 and 13

Resin compositions of Example 12 and Example 13 are respectively produced in the same manner as in Example 1 except that the component (C-1) used in Example 1 is replaced with the components (C-4) and (C-5), respectively. The characteristics of the resin compositions of Examples 12 and 13 and the cured products obtained by curing the resin compositions are measured in the same manner as in Example 1. It is assumed that Example 12 and Example 13 can be similarly cured by heating at a low temperature of 80°C or lower and can have a long pot life.

In Examples and Comparative Examples, characteristics of the curable resin composition and the cured product were measured as follows. Results are shown in Tables 1 and 2.

### Viscosity of curable resin composition

Using a Brookfield rotational viscometer (HBDV-I type or RVDV-I type, spindle: SC4-14 spindle, rotation speed: 50rpm, measurement temperature: 25°C), the viscosity of the curable resin composition was measured as an initial viscosity at 25°C within 1 hour after preparation of the curable resin composition. The viscosity of the curable resin composition after standing at 25°C for 10 hours was taken as 10-hour (10 hr) viscosity. The viscosity of the curable resin composition after standing at 25°C for 24 hours was taken as 24-hour (24 hr) viscosity.

### Pot life

Using a Brookfield rotational viscometer (HBDV-I type or RVDV-I type, spindle: SC4-14 spindle, rotation speed: 50rpm, measurement temperature: 25°C), the viscosity of the curable resin composition was measured at 25°C within 1 hour after the preparation of the curable resin composition. Next, in an environment of 25°C and a humidity of 50%, a part of the curable resin composition stored in a sealed container was taken out from the sealed container after 10 and 24 hours, and the viscosity of the curable resin composition was measured. When a thickening ratio of the viscosity from measurement of the initial viscosity to until after 10 hours (viscosity after 10 hours/initial viscosity) was 1.0 times or less, it was rated as excellent (Excellent, "E"), when the thickening ratio was more than 1.0 times and 2.0 times or less, it was rated as good (Good, "G"), and when the thickening ratio was more than 2.0 times, it was rated as not good (Bad, "B"). In addition, when the thickening ratio of the viscosity until after 24 hours (viscosity after 24 hours/initial viscosity) was 1.0 times or less, it was rated as excellent (Excellent, "E"), when the thickening ratio was higher than 1.0 times and 5.0 times or less, it was rated as good (Good, "G"), and when the thickening ratio was more than 5 times, it was rated as not good (Bad, "B"). In Table 2, "> 5.0" indicates that the thickening ratio of the viscosity until after 24 hours is more than 5.0.

### Preparation of cured product

Each of the curable resin compositions of Examples 1 to 11 and Comparative Example 1 was heated at 80°C for 60 minutes using a blower dryer to obtain a cured product.

### Curability at 80°C

First, a Teflon (registered trademark) sheet was attached to a surface of a glass plate having a thickness of 3 mm, and spacers (obtained by stacking heat-resistant tapes) were arranged at two locations thereon so that a film thickness when cured was 400±150 µm. Next, the curable resin composition was applied between the spacers, and the glass plate was sandwiched between other glass plates having a Teflon (registered trademark) sheet attached to a surface thereof so as not to catch bubbles, and was cured by heating at 80°C for 60 minutes using a blower dryer. When the curable resin composition was solid and had no tackiness, it was rated as excellent (Excellent, "E"), when the curable resin composition was solid and had tackiness, it was rated as good (Good, "G"), and when the curable resin composition was liquid and was not cured, it was rated as not good (Bad, "B"). By sandwiching with the glass plates, the curability can be determined without considering influence of the inhibition by oxygen.

**[Table 1]**

| | | | | Example 1 | Example 2 | Example 3 | Example 4 | Example 5 | Example 6 |
|---|---|---|---|---|---|---|---|---|---|
| (A) | (A1) | (A1-1) | AER9000 | 13.89 | 48.36 | 13.89 | - | 92.4 | 82.4 |
| | | (A1-2) | EXA-850CRP | - | - | - | 18.65 | - | - |
| | | (A1-3) | YX8000 | 22.47 | - | 22.47 | 29.65 | - | - |
| | | (A1-4) | 2021P | 9.5 | 16.54 | 9.5 | - | - | - |
| | | (A1-5) | ED-509S | - | - | - | - | - | - |
| | (A2) | (A2-1) | OXT-221 | 15.64 | - | 15.64 | 11.6 | - | - |
| | | (A2-2) | OXT-101 | - | - | - | - | - | - |
| (B) | (B-1) | | PI2074 | 3 | - | 2 | 2 | 1 | 1 |
| | (B-2) | | IK-1FG | - | 1 | - | - | - | - |
| (C) | (C-1) | | Perkadox24L | 0.2 | 0.5 | 1 | 2 | 3 | 3 |
| | (C-2) | | Perkadox26 | - | - | - | - | - | - |
| | (C-3) | | PEROYL TCP | - | - | - | - | - | - |
| (C') | (C'-1) | | Lupelox 225 | - | - | - | - | - | - |
| (D) | (D-1) | | DETX | 0.1 | 0.1 | 0.1 | 0.1 | 0.1 | 0.1 |
| (E) | (E-1) | | Omniradl84 | - | - | - | - | - | - |
| (F) | (F-1) | | SE5200SEE | 30 | 30 | 30 | 22 | - | - |
| | (F-2) | | TS720 | 3 | 3 | 3 | 10 | - | 10 |
| (G) | (G-1) | | S530 | 1.8 | 0.5 | 2 | 3 | 3.5 | 3.5 |
| (H) | (H-1) | | IXEPLAS-A1 | - | - | - | 1 | - | - |
| (I) | (I-1) | | Titan Black 13M | 0.4 | - | 0.4 | - | - | - |
| tatal: | | | | 100 | 100 | 100 | 100 | 100 | 100 |
| Curability at 80°C | | | | E | E | E | E | E | E |
| Initial viscosity (Pa·s) | | | | 4.1 | 3.5 | 3.9 | 22.7 | 1.0 | 18.6 |
| 10 hr (Pa·s) | | | | 4.1 | 3.5 | 3.9 | 22.7 | 1.0 | 18.6 |
| 24 hr (Pa·s) | | | | 4.0 | 3.7 | 4.4 | 37.8 | 1.1 | 18.2 |
| Thickening ratio after 10 hr | | | | 1.0 | 1.0 | 1.0 | 1.0 | 1.0 | 1.0 |
| Evaluation | | | | E | E | E | E | E | E |
| Thickening ratio after 24 hr | | | | 1.0 | 1.1 | 1.1 | 1.7 | 1.0 | 1.0 |
| Evaluation | | | | E | G | G | G | E | E |

**[Table 2]**

| | | | | Example 7 | Example 8 | Example 9 | Example 10 | Example 11 | Comparative Example 1 |
|---|---|---|---|---|---|---|---|---|---|
| (A) | (A1) | (A1-1) | AER9000 | - | - | 23.15 | 13.89 | 13.89 | 13.89 |
| | | (A1-2) | EXA-850CRP | 17.16 | 14.54 | - | - | - | - |
| | | (A1-3) | YX8000 | - | - | 18.73 | 22.47 | 22.47 | 22.47 |
| | | (A1-4) | 2021P | 6.48 | 16.48 | 3.96 | 9.5 | 9.5 | 9.5 |
| | | (A1-5) | ED-509S | - | 17.41 | 6.28 | - | - | - |
| | (A2) | (A2-1) | OXT-221 | 37.36 | 13.57 | 6 | 15.64 | 15.64 | 15.64 |
| | | (A2-2) | OXT-101 | - | - | 3.78 | - | - | - |
| (B) | (B-1) | | PI2074 | 2 | 2 | 2 | 2 | 2 | 2 |
| | (B-2) | | IK-1FG | - | - | - | - | - | - |
| (C) | (C-1) | | Perkadox24L | 1 | 1 | - | - | 6 | - |
| | (C-2) | | Perkadox26 | - | - | 1 | - | - | - |
| | (C-3) | | PEROYL TCP | - | - | - | 1 | - | - |
| (C') | (C'-1) | | Lupelox 225 | - | - | - | - | - | 1 |
| (D) | (D-1) | | DETX | - | - | 0.1 | 0.1 | 0.1 | 0.1 |
| (E) | (E-1) | | Omnirad184 | 1 | - | - | - | - | - |
| (F) | (F-1) | | SE5200SEE | 30 | 30 | 30 | 30 | 25 | 30 |
| | (F-2) | | TS720 | 3 | 3 | 3 | 3 | 3 | 3 |
| (G) | (G-1) | | S530 | 2 | 2 | 2 | 2 | 2 | 2 |
| (H) | (H-1) | | IXEPLAS-A1 | - | - | - | - | - | - |
| (I) | (I-1) | | Titan Black 13M | - | - | - | 0.4 | 0.4 | 0.4 |
| tatal: | | | | 100 | 100 | 100 | 100 | 100 | 100 |
| Curability at 80°C | | | | E | E | E | E | E | E |
| Initial viscosity (Pa·s) | | | | 5.0 | 7.9 | 2.3 | 3.8 | 4.0 | 3.7 |
| 10 hr (Pa·s) | | | | 5.0 | 7.9 | 2.3 | 3.8 | 4.0 | 4.8 |
| 24 hr (Pa·s) | | | | 5.0 | 7.9 | 2.5 | Cured | 7.6 | Cured |
| Thickening ratio after 10 hr | | | | 1.0 | 1.0 | 1.0 | 1.0 | 1.0 | 1.3 |
| Evaluation | | | | E | E | E | E | E | G |
| Thickening ratio after 24 hr | | | | 1.0 | 1.0 | 1.1 | > 5.0 | 1.9 | > 5.0 |
| Evaluation | | | | E | E | G | B | G | B |

As shown in Tables 1 and 2, the cured product of each of the curable resin compositions of Examples 1 to 11 had good curability, could be cured by heating at a low temperature of, for example, 100°C or lower, preferably 80°C or lower, had a thickening ratio of 1.0 until after 10 hours, and had an excellent pot life. After 24 hours, Example 10 was cured with a thickening ratio more than 2.0. Further, the Tg obtained in Examples were all in a range of 0°C to 200°C. Furthermore, the Tg's obtained in Examples excluding Examples 4, 7, and 8 were all in a range of 0°C to 150°C.

Comparative Example 1 could be cured at 80°C, but thickening was observed after 10 hours, and an effect of pot life was impaired.

### INDUSTRIAL APPLICABILITY

The curable resin composition according to the present invention can be suitably used as the adhesive or the sealing material for fixing, bonding, or protecting the components constituting the electronic device. The resin composition, the adhesive or the sealing material containing the resin composition, a cured product obtained by curing a die attach agent, and the electronic device containing the cured product of the embodiment of the present invention can be used for, for example, a mobile phone, a smartphone, a notebook computer, a tablet terminal, a camera module, a sensor module, and the like.

## Claims

1. A curable resin composition comprising the following components (A) to (C):
(A) a cationically curable resin;
(B) an acid generator containing an iodonium salt; and
(C) a peroxydicarbonate-type organic peroxide represented by the following Formula (1): 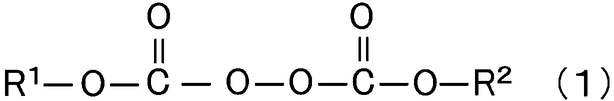 (in Formula (1), R¹ and R² are each independently an alkyl group having at least 10 carbon atoms).

2. The curable resin composition according to claim 1, wherein in Formula (1), R¹ and R² are each independently a linear, branched, or cyclic alkyl group having at least 11 carbon atoms, or a combination of these three.

3. The curable resin composition according to claim 1 or 2, wherein the iodonium salt contained in the component (B) is an iodonium salt compound represented by the following Formula (2):
Ar¹ - I⁺ - Ar² ·Z⁻ (2)
(in Formula (2), Ar¹ and Ar² are each independently a substituted or unsubstituted aryl group, and Z⁻ is an anion).

4. The curable resin composition according to claim 3, wherein Z⁻ in Formula (2) is BF₄⁻, SbF₆⁻, AsF₆⁻, B(C₆F₅)₄⁻, Ga(C₆F₅)₄⁻, C(CF₃SO₂)₃⁻, [P(R³)ₐF₆₋ₐ]⁻, [C(R³SO₂)₃]⁻, or [N(R³SO₂)₂]⁻ (where R³s are each independently an alkyl group in which at least a part of hydrogen atoms is substituted with a fluorine atom, a is an integer of 0 to 5, and in a case where a is an integer of 2 or more, a plurality of R³s are the same or different from each other).

5. The curable resin composition according to any one of claims 1 to 4, wherein the component (A) comprises at least one selected from the group consisting of:
(A1) an epoxy resin having an epoxy group equivalent of 100 g/eq to 1000 g/eq and having a ring skeleton in a molecule of the epoxy resin; and
(A2) an oxetane resin.

6. The curable resin composition according to claim 5, wherein the component (A1) comprises an epoxy resin having an epoxy group equivalent of 200 g/eq or more.

7. The curable resin composition according to any one of claims 1 to 6, wherein an amount of the component (C) is 0.1 to 10 parts by mass when a total amount of the curable resin composition is 100 parts by mass.

8. An adhesive or a sealing material comprising the curable resin composition according to any one of claims 1 to 7.

9. A cured product obtained by curing the curable resin composition according to any one of claims 1 to 7, or the adhesive or the sealing material according to claim 8.

10. The cured product according to claim 9, wherein the cured product has a glass transition temperature (Tg) of 0°C to 200°C.

11. A semiconductor device comprising the cured product according to claim 9 or 10.

12. An electronic device comprising the cured product according to claim 9 or 10.
